# EUROPEAN PATENT APPLICATION

(11) **EP 2 317 547 A1**
(43) Date of publication of application: **04.05.2011**
(21) Application number: 10186708.3
(22) Date of filing: 06.10.2010
(51) Int. Cl.: H01L 23/29, H01L 23/31, H01L 33/50, H01L 33/56, H01L 33/54

(54) **Kit for optical semiconductor encapsulation**

(30) Priority: 07.10.2009 JP 2009233346
(71) Applicant: Nitto Denko Corporation, Ibaraki-shi Osaka 567-8680 (JP)
(72) Inventor: Matsuda, Hirokazu, Ibaraki-shi Osaka 567-8680 (JP); Akazawa, Koji, Ibaraki-shi Osaka 567-8680 (JP); Fujioka, Kazuya, Ibaraki-shi Osaka 567-8680 (JP)
(74) Representative: Grünecker, Kinkeldey, Stockmair & Schwanhäusser Anwaltssozietät

(57) **Abstract**

The present invention relates to a kit for optical semiconductor encapsulation including a liquid first encapsulating material containing inorganic particles and a liquid second encapsulating material containing a phosphor, a kit for optical semiconductor encapsulation including a sheet-shaped first encapsulating material containing inorganic particles and a liquid second encapsulating material containing a phosphor; and a kit for optical semiconductor encapsulation including a liquid first encapsulating material containing inorganic particles and a sheet-shaped second encapsulating material containing a phosphor.

## Description

### FIELD OF THE INVENTION

The present invention relates to a kit for optical semiconductor encapsulation. More particularly, the invention relates to a package for encapsulating a light emitting element such as a light emitting diode or a semiconductor laser, and relates to a kit for optical semiconductor encapsulation for inhibiting an increase in temperature of an encapsulating resin at the time of lighting the light emitting element and an optical semiconductor device encapsulated with the kit.

### BACKGROUND OF THE INVENTION

Generally, methods for emitting white light using a blue LED include a method of coating an LED chip with a phosphor-containing resin, a method of potting a phosphor-containing resin to a cap-shaped LED device, and further, a method of laminating sheet-shaped phosphor-containing resin layers, followed by encapsulation.

For example, patent document 1 discloses a light emitting device in which a translucent resin is encapsulated around an LED chip and cured, followed by encapsulating the cured translucent resin with a fluorescent material-containing resin. In such a device, the fluorescent material can be almost uniformly distributed in an upper surface direction in which the emission intensity of the LED chip is strong, so that it becomes possible to prevent color heterogeneity of an emission color of the light emitting element, and to improve the efficiency of wavelength conversion due to the fluorescent material. Further, the use of the expensive fluorescent material is reduced, which makes it possible to realize the low-cost light emitting element.

Patent Document 1: JP-A-2000-156528

### SUMMARY OF THE INVENTION

However, in an optical semiconductor device having such a structure as described in patent document 1, emitted light is irradiated as such to the fluorescent material which lies directly on the LED chip, so that there is a problem that the temperature of the fluorescent material-containing resin portion (phosphor-containing resin) extremely increases by loss energy at the time of wavelength conversion, resulting in easy deterioration of the resin.

An object of the invention is to provide a kit for optical semiconductor encapsulation including an encapsulating resin (translucent resin) for coating an LED chip and a resin containing a phosphor (phosphor-containing resin) disposed on the resin, in which the kit is capable of inhibiting an increase in temperature of an encapsulating resin at the time of lighting-up of an LED; and an optical semiconductor device encapsulated with the kit.

The present inventors have made intensive studies in order to solve the above-mentioned problem. As a result, it has been found that, in a kit for optical semiconductor encapsulation including a first encapsulating material of a translucent resin and a second encapsulating material of a phosphor-containing resin, an increase in temperature of the second encapsulating material can be inhibited by dispersing inorganic particles in the first encapsulating material, thus leading to the completion of the invention.

Namely, the present invention relates to the following items (1) to (7).
(1) A kit for optical semiconductor encapsulation including:
   a liquid first encapsulating material containing inorganic particles; and
   a liquid second encapsulating material containing a phosphor.
(2) A kit for optical semiconductor encapsulation including:
   a sheet-shaped first encapsulating material containing inorganic particles; and
   a liquid second encapsulating material containing a phosphor.
(3) A kit for optical semiconductor encapsulation including:
   a liquid first encapsulating material containing inorganic particles; and
   a sheet-shaped second encapsulating material containing a phosphor.
(4) The kit for optical semiconductor encapsulation according to any one of (1) to (3), in which a constituent resin of the first encapsulating material contains a silicone resin.
(5) The kit for optical semiconductor encapsulation according to any one of (1) to (4), in which the inorganic particles contain at least one selected from the group consisting of silicon dioxide and barium sulfate,
(6) The kit for optical semiconductor encapsulation according to any one of (1) to (5), in which a constituent resin of the second encapsulating material contains a silicone resin.
(7) An optical semiconductor device including:
   an optical semiconductor element; and
   the kit for optical semiconductor encapsulation according to any one of (1) to (6),
   in which the optical semiconductor element is encapsulated with the first encapsulating material and the second encapsulating material in this order.

The kit for optical semiconductor encapsulation of the invention is a kit for optical semiconductor encapsulation including, as constituents, a first encapsulating material of a translucent resin and a second encapsulating material of a phosphor-containing resin, and exhibits an excellent effect that an increase in temperature of the second encapsulating material at the time of lighting-up of an LED can be inhibited.

### BRIEF DESCRIPTION OF THE DRAWING

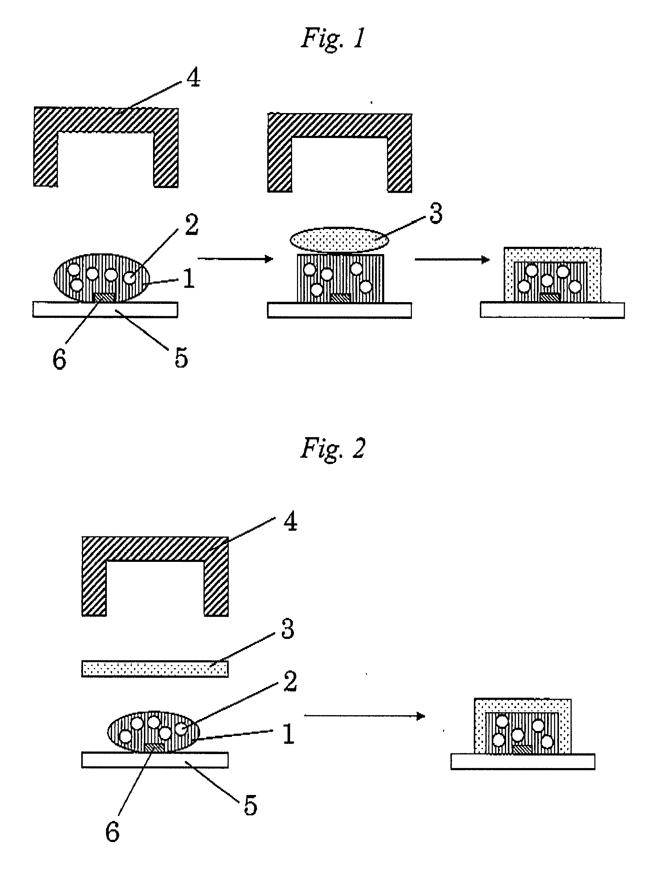

Fig. 1 is a view illustrating encapsulation of an LED chip with a kit for optical semiconductor encapsulation of embodiment 1 of the invention, in which the left shows a state where a first encapsulating material is potted; the center shows a state where a second encapsulating material is potted after encapsulation with the first encapsulating material; and the right shows a state after encapsulation with all the encapsulating materials.
Fig. 2 is a view illustrating encapsulation of an LED chip with a kit for optical semiconductor encapsulation of embodiment 3 of the invention, in which the left shows a state before encapsulation; and the right shows a state after encapsulation.

### DETAILED DESCRIPTION OF THE INVENTION

In the kit for optical semiconductor encapsulation of the invention, the kit includes, as constituents, a first encapsulating material and a second encapsulating material, in which the first encapsulating material contains inorganic particles and the second encapsulating material contains a phosphor. An optical semiconductor device encapsulated by using the kit having such a constitution is specifically obtained by encapsulating an LED chip (optical semiconductor element) with the first encapsulating material and the second encapsulating material in this order. Accordingly, light emitted from the LED passes through the first encapsulating material, the wavelength thereof is converted by the phosphor in the second encapsulating material, followed by being radiated as such. Therefore, the emitted light having high luminance is obtained. However, the emitted light which has passed thorough the first encapsulating material reaches the phosphor as such, and the wavelength thereof is converted there. Accordingly, loss energy of the phosphor at the time of wavelength conversion is absorbed by the second encapsulating material, resulting in an increase in temperature of the second encapsulating material. In the invention, therefore, the light reaching the second encapsulating material can be dispersed by a light scattering effect of the inorganic particles by incorporating the inorganic particles into the first encapsulating material, so that the heat generation density (heat generation amount per unit volume of the encapsulating material) due to the phosphor is decreased. As a result, it is considered that heat generation can be inhibited as a whole. Incidentally, as the kit for semiconductor encapsulation of the invention, the following three embodiments are exemplified according to the shape of each constituent.
Embodiment 1: an embodiment including a liquid first encapsulating material containing the inorganic particles and a liquid second encapsulating material containing the phosphor;
Embodiment 2: an embodiment including a sheet-shaped first encapsulating material containing the inorganic particles and a liquid second encapsulating material containing the phosphor; and
Embodiment 3: an embodiment including a liquid first encapsulating material containing the inorganic particles and a sheet-shaped second encapsulating material containing the phosphor.

The first encapsulating materials of embodiments 1 to 3 contain the inorganic particles.

The inorganic particles are not particularly limited, as long as they can scatter visible light. However, the inorganic particles preferably include at least one selected from the group consisting of silicon dioxide and barium sulfate, and more particularly particles containing silicon dioxide, because of no decrease in luminance by encapsulation processing.

The average particle size of the inorganic particles may be any, as long as it can scatter visible light and is equal to or less than the thickness of a layer formed by the first encapsulating material. It is preferably from 0.1 to 200 µm, and more preferably from 0.3 to 40 µm. Further, it is still more preferably from 5 to 40 µm, from the viewpoint of inhibiting a decrease in temperature by encapsulation processing. Incidentally, in this specification, the average particle size of the inorganic particles can be measured by a method described in the example described later.

The shape of the inorganic particles may be any, as long as it can scatter visible light, and a spherical shape and a crushed shape are exemplified. However, a spherical shape is preferred from the viewpoint of inhibiting a decrease in luminance of the LED.

The content of the inorganic particles in the first encapsulating material is preferably from 0.1 to 70% by weight from the viewpoints of being uniformly dispersible in the first encapsulating material and inhibiting an increase in temperature of the second encapsulating material. Further, it is more preferably from 0.1 to 55% by weight from the viewpoint of inhibiting a decrease in luminance of the LED.

A constituent resin of the first encapsulating material is not particularly limited as long as it is a resin which has been conventionally used for optical semiconductor encapsulation. Examples thereof include translucent resins such as silicone resins, epoxy resins, styrene resins, acrylic resins, polycarbonate resins, urethane resins and polyolefin resin. These may be used either alone or as a combination of two or more thereof. Above all, silicone resins are preferred from the viewpoint of durability.

The second encapsulating materials of embodiments 1 to 3 contain the phosphor.

The phosphor is not particularly limited, and examples thereof include known phosphors used in the optical semiconductor device. Specifically, a yellow phosphor (α-sialon), YAG, TAG and the like are exemplified as suitable commercially available phosphors having a function of converting a blue color to a yellow color.

The content of the phosphor is not sweepingly determined, because the degree of color mixture varies depending on the kind of phosphor and the thickness of the layer formed by the second encapsulating material.

A constituent resin of the second encapsulating material is not particularly limited as long as it is a resin which has been conventionally used for optical semiconductor encapsulation. The resins exemplified as the constituent resins of the second encapsulating material are similarly exemplified as those of the first encapsulating material. These may be used either alone or as a combination of two or more thereof. Above all, silicone resins are preferred from the viewpoint of durability.

In addition to the above-mentioned inorganic particles, phosphor and constituent resins, additives such as a curing agent, a curing accelerator, an aging inhibitor, a modifier, a surfactant, dyes, a pigment, a discoloration inhibitor and an UV absorber may be incorporated as raw material into the first encapsulating material and the second encapsulating material.

The first encapsulating material and the second encapsulating material can be prepared by methods known to persons skilled in the art as long as the above-mentioned compositions are obtained. Detailed description will be made below for each shape.

For example, the liquid encapsulating material is obtained by adding the inorganic particles for the first encapsulating material and the phosphor for the second encapsulating material, respectively, to the constituent resin of the encapsulating material or an organic solvent solution of the resin. A mixing method is not particularly limited. Incidentally, the organic solvent is not particularly limited, and a solvent known in the art can be used.

The sheet-shaped encapsulating material can be formed, for example, by adding the inorganic particles for the first encapsulating material and the phosphor for the second encapsulating material, respectively, to the constituent resin of the encapsulating material or the organic solvent solution of the resin, followed by mixing with stirring, applying the resulting material, for example, onto a release sheet (for example, an polyethylene substrate) whose surface is release-treated, to an appropriate thickness by using an applicator or the like, and drying it by heating at such a temperature that the solvent is removable. The heating temperature cannot be sweepingly determined, because it varies depending on the kind of resin or solvent. However, it is preferably from 80 to 150°C, and more preferably from 90 to 150°C. Incidentally, a sheet obtained by laminating a plurality of sheets and pressing them by hot pressing at 20 to 100°C to integrate them may be used as one sheet-shaped encapsulating material. The thickness of the sheet-shaped first encapsulating material is different from that of the sheet-shaped second encapsulating material. The thickness of the sheet-shaped first encapsulating material is preferably from 100 to 1,000 µm, and more preferably from 300 to 800 µm, from the viewpoint of encapsulation properties for the optical semiconductor element, and the thickness of the sheet-shaped second encapsulating material is preferably from 20 to 300 µm, and more preferably from 30 to 200 µm, from the viewpoints of phosphor concentration and coating properties.

Thus, the first and second encapsulating materials having various shapes are obtained. The kit for optical semiconductor encapsulation of the invention can contain another encapsulating material other than the above-mentioned first and second encapsulating materials from the viewpoint of an increase in luminance, as long as the second encapsulating material is disposed more apart from the LED chip than the first encapsulating material. For example, when the first encapsulating material is a sheet-shaped encapsulating material, a liquid encapsulating material (also referred as a third encapsulating material) including a translucent resin is used from the viewpoint of adhesiveness to the substrate. In this case, the third encapsulating material, the first encapsulating material and the second encapsulating material are used on the substrate in this order. A constituent resin of the third encapsulating material is not particularly limited, but is preferably the same as the constituent resin of the first encapsulating material.

Further, the invention provides the optical semiconductor device encapsulated with the kit for optical semiconductor encapsulation of the invention. Such a device is a device in which encapsulation is performed on the optical semiconductor element by using the first encapsulating material and the second encapsulating material in this order, and is not particularly limited as long as the first encapsulating material and the second encapsulating material are used in this order. The device can be produced by methods known to persons skilled in the art. The kit for optical semiconductor encapsulation used will be described below for each embodiment.

The optical semiconductor device using the kit for optical semiconductor encapsulation of embodiment 1 is obtained by first potting the liquid first encapsulating material on the LED chip, followed by curing, and then, potting the second encapsulating material on the first encapsulating material, followed by curing.

The optical semiconductor device using the kit for optical semiconductor encapsulation of embodiment 2 is obtained by first laminating the sheet-shaped first encapsulating material on the LED chip, followed by curing, and then, potting the second encapsulating material on the first encapsulating material, followed by curing. Incidentally, when the third encapsulating material is used, the device is obtained by potting the liquid third encapsulating material on the LED chip, followed by curing, laminating the sheet-shaped first encapsulating material thereon, followed by curing, and then, potting the second encapsulating material on the first encapsulating material, followed by curing.

The optical semiconductor device using the kit for optical semiconductor encapsulation of embodiment 3 is obtained by first potting the liquid first encapsulating material on the LED chip, and then, laminating the sheet-shaped second encapsulating material thereon, followed by curing as a whole.

Curing of the resin in each embodiment can be performed according to methods known to persons skilled in the art, for example, by using a mold and heating under a pressure of preferably 0.1 to 0.5 MPa, more preferably 0.1 to 0.3 MPa, preferably at 100 to 160°C for 1 to 10 minutes. Incidentally, in the case of pressure molding, after standing until the shape becomes invariable even under room temperature, the mold is taken off and post cure can be performed. The post cure can be performed, for example, by standing preferably for 15 minutes to 6 hours using a dryer preferably having a temperature of 100 to 150°C.

The optical semiconductor device of the invention contains, as the encapsulating material, the kit for optical semiconductor encapsulation of the invention in which an increase in temperature of the encapsulating resin is inhibited. Accordingly, even in the optical semiconductor device equipped with a high-intensity LED element such as a blue element, a green LED element or the like, an increase in temperature of the encapsulating material is inhibited to inhibit deterioration thereof, while taking out the light emitting luminance in a high state. It can therefore be suitably used.

### EXAMPLES

The invention will be described below with reference to examples, comparative example and reference example. However, the invention is not construed as being limited by these examples.

### [Average Particle Size of Inorganic Particles]

In this specification, the average particle size of inorganic particles means the average particle size of primary particles and means 50% volume cumulative diameter (D₅₀) measured by a dynamic light scattering method for a particle-dispersed solution of the inorganic particles and calculated.

### Example 1

### <First Encapsulating Material>

To 9.95 g of silicone elastomer (ELASTOSIL LR-7665 manufactured by Wacker Asahikasei Silicone Co., Ltd.), 0.05 g (inorganic particle content: 0.5% by weight) of silicon dioxide (FB-7SDC manufactured by Denki Kagaku Kogyo K.K., average particle size: 5.8 µm, spherical) was added, and uniformly dispersed by hand stirring to obtain a liquid silicon dioxide-containing resin.

### <Second Encapsulating Material>

To 8.4 g of silicone elastomer (LR-7665), 1.6 g (phosphor content: 16% by weight) of YAG was added, and uniformly dispersed by hand stirring to obtain a liquid phosphor-containing resin.

### <Optical Semiconductor Encapsulation>

A moderate amount of the liquid first encapsulating material was placed on a flat substrate on which an optical semiconductor element (wavelength region: 450 nm) was mounted. A mold having a diameter of 8 mm and a height of 500 µm was placed thereon, and pressed using a vacuum press apparatus (V-130 manufactured by Nichigo-Morton Co., Ltd.) for 5 minutes under conditions of 0.1 MPa and 160°C, thereby performing encapsulation with the first encapsulating material. Then, a moderate amount of the liquid second encapsulating material was placed on the first encapsulating material, and pressure molding was performed in the same manner as described above to obtain an optical semiconductor device.

### Example 2

### <First Encapsulating Material>

To 9.95 g of silicone elastomer (LR-7665), 0.05 g (inorganic particle content: 0.5% by weight) of silicon dioxide (FB-7SDC) was added, and uniformly dispersed by hand stirring to obtain a liquid silicon dioxide-containing resin.

### <Second Encapsulating Material>

To 8.4 g of silicone elastomer (LR-7665), 1.6 g (phosphor content: 16% by weight) of YAG was added, and uniformly dispersed by hand stirring. The resulting phosphor-containing resin was applied to a thickness of 100 µm by using an applicator, and dried at 100°C for 10 minutes to obtain a phosphor-containing resin sheet.

### <Optical Semiconductor Encapsulation>

A moderate amount of the liquid first encapsulating material was placed on a flat substrate on which an optical semiconductor element (wavelength region: 450 nm) was mounted, and the phosphor-containing resin sheet was placed thereon. A mold having a diameter of 8 mm and a height of 500 µm was placed thereon, and pressed using a vacuum press apparatus (V-130) for 5 minutes under conditions of 0.1 MPa and 160°C, thereby obtaining an optical semiconductor device.

### Example 3

An optical semiconductor device was obtained in the same manner as in Example 2 with the exception that the amounts of silicone elastomer (LR-7665) and silicon dioxide (FB-7SDC) in the first encapsulating material were changed to 9.5 g and 0.5 g (inorganic particle content: 5% by weight), respectively.

### Example 4

An optical semiconductor device was obtained in the same manner as in Example 2 with the exception that the amounts of silicone elastomer (LR-7665) and silicon dioxide (FB-7SDC) in the first encapsulating material were changed to 7.0 g and 3.0 g (inorganic particle content: 30% by weight), respectively.

### Example 5

An optical semiconductor device was obtained in the same manner as in Example 2 with the exception that the amounts of silicone elastomer (LR-7665) and silicon dioxide (FB-7SDC) in the first encapsulating material were changed to 5.0 g and 5.0 g (inorganic particle content: 50% by weight), respectively.

### Example 6

An optical semiconductor device was obtained in the same manner as in Example 2 with the exception that the amounts of silicone elastomer (LR-7665) and silicon dioxide (FB-7SDC) in the first encapsulating material were changed to 3.0 g and 7.0 g (inorganic particle content: 70% by weight), respectively.

### Example 7

An optical semiconductor device was obtained in the same manner as in Example 4 with the exception that the kind of silicon dioxide in the first encapsulating material was changed to silicon dioxide (FB-40S manufactured by Denki Kagaku Kogyo K.K., average particle size: 39.8 µm, spherical).

### Example 8

An optical semiconductor device was obtained in the same manner as in Example 4 with the exception that the kind of silicon dioxide in the first encapsulating material was changed to silicon dioxide (SFP-20M manufactured by Denki Kagaku Kogyo K.K., average particle size: 0.3 µm, spherical).

### Example 9

An optical semiconductor device was obtained in the same manner as in Example 4 with the exception that the kind of silicon dioxide in the first encapsulating material was changed to silicon dioxide (Crystalite 5X manufactured by Tatsumori Ltd., average particle size: 1.5 µm, crushed shape).

### Example 10

An optical semiconductor device was obtained in the same manner as in Example 3 with the exception that the kind of inorganic particles in the first encapsulating material was changed to barium sulfate (W-6 manufactured by Takehara Kagaku Kogyo Co., Ltd., average particle size: 5.0 µm, crushed shape).

### Example 11

An optical semiconductor device was obtained in the same manner as in Example 5 with the exception that the kind of silicon dioxide in the first encapsulating material was changed to silicon dioxide (FB-40S).

### Comparative Example 1

An optical semiconductor device was obtained in the same manner as in Example 2 with the exception that no inorganic particles were added to the first encapsulating material.

### Reference Example 1

An optical semiconductor device was obtained in the same manner as in Example 3 with the exception that the kind of inorganic particles in the first encapsulating material was changed to alumina (AS-50 manufactured by Showa Denko K.K., average particle size: 9 µm, spherical).

For the resulting optical semiconductor devices, characteristics were evaluated according to the following test examples 1 and 2. The results thereof are shown in Table 1.

### Test Example 1 (Temperature of Second Encapsulating Material)

A moderate amount of heat radiation silicone (SCH-30 manufactured by Sunhayato Corp., thermal conductivity: 0.96 W/mK) was dropped onto a heat sink (material: copper), and the optical semiconductor device was fixed thereon. The current value was increased at 100 mA/sec until 10 seconds from the start of lighting, and after 3 minutes from reaching 500 mA, the maximum temperature of the second encapsulating material was measured. Incidentally, temperature measurement was performed by using a thermograph (CPA1000 manufactured by Chino Corp.) and focusing from above of the optical semiconductor device on lighting. Further, the lower encapsulating material temperature is preferred.

### Test Example 2 (Light Emitting Luminance)

Each optical semiconductor device was lighted at 50 mA, and the light emitting luminance at that time was measured according to hemispherical luminance measurement. Incidentally, an integrating sphere was used for luminance measurement, and the measurement was performed by using a multiple photometric system (MCPD-3000 manufactured by Otsuka Electronics Co., Ltd.). Further, the light emitting luminance (Y value) is more preferably 2,000 or more.

**Table 1**

| | First Encapsulating Material | | | | | Second Encapsulating Material | Characteristics | |
|---|---|---|---|---|---|---|---|---|
| | Shape of Material | Inorganic Particles | | | | Shape of Material | Second Encapsulating Material Temperature (°C) | Light Emitting Luminance (Y Value) |
| | | Kind | Average Particle Size | Shape (µm) | Content (wt%) | | | |
| Example 1 | Liquid | Silicon dioxide | 5.8 | Spherical | 0.5 | Liquid | 171 | 2070 |
| Example 2 | Liquid | Silicon dioxide | 5.8 | Spherical | 0.5 | Sheet | 188 | 2058 |
| Example 3 | Liquid | Silicon dioxide | 5.8 | Spherical | 5 | Sheet | 169 | 2150 |
| Example 4 | Liquid | Silicon dioxide | 5.8 | Spherical | 30 | Sheet | 123 | 2083 |
| Example 5 | Liquid | Silicon dioxide | 5.8 | Spherical | 50 | Sheet | 98 | 1855 |
| Example 6 | Liquid | Silicon dioxide | 5.8 | Spherical | 70 | Sheet | 91 | 1733 |
| Example 7 | Liquid | Silicon dioxide | 39.8 | Spherical | 30 | Sheet | 149 | 2156 |
| Example 8 | Liquid | Silicon dioxide | 0.3 | Spherical | 30 | Sheet | 110 | 1823 |
| Example 9 | Liquid | Silicon dioxide | 1.5 | Crushed | 30 | Sheet | 95 | 858 |
| Example 10 | Liquid | Barium sulfate | 5.0 | Crushed | 5 | Sheet | 156 | 1886 |
| Example 11 | Liquid | Silicon dioxide | 39.8 | Spherical | 50 | Sheet | 120 | 2087 |
| Comparative Example 1 | Liquid | --- | --- | --- | --- | Sheet | 200 | 2033 |
| Reference Example 1 | Liquid | Alumina | 9 | Spherical | 5 | Sheet | 225 | 1712 |

From Table 1, in the optical semiconductor devices containing silicon dioxide or barium sulfate, increases in temperature of the second encapsulating materials are inhibited.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2009-233346 filed on October 7, 2009, and the contents are incorporated herein by reference.
All references cited herein are incorporated by reference herein in their entirety.

### INDUSTRIAL APPLICABILITY

The kit for optical semiconductor encapsulation of the invention are suitably used, for example, when semiconductor elements of backlights for liquid-crystal screens, traffic signals, large outdoor displays, advertising signboards and the like are produced,

### Description of Reference Numerals and Signs

1: First encapsulating material
2: Inorganic particles
3: Phosphor-containing second encapsulating material
4: Mold
5: Substrate
6: LED chip

## Claims

1. A kit for optical semiconductor encapsulation comprising:
a liquid first encapsulating material containing inorganic particles; and
a liquid second encapsulating material containing a phosphor.

2. A kit for optical semiconductor encapsulation comprising:
a sheet-shaped first encapsulating material containing inorganic particles; and
a liquid second encapsulating material containing a phosphor.

3. A kit for optical semiconductor encapsulation comprising:
a liquid first encapsulating material containing inorganic particles; and
a sheet-shaped second encapsulating material containing a phosphor.

4. The kit for optical semiconductor encapsulation according to any one of claims 1 to 3, wherein a constituent resin of the first encapsulating material contains a silicone resin.

5. The kit for optical semiconductor encapsulation according to any one of claims 1 to 4, wherein the inorganic particles contain at least one selected from the group consisting of silicon dioxide and barium sulfate.

6. The kit for optical semiconductor encapsulation according to any one of claims 1 to 5, wherein a constituent resin of the second encapsulating material contains a silicone resin.

7. An optical semiconductor device comprising:
an optical semiconductor element; and
the kit for optical semiconductor encapsulation according to any one of claims 1 to 6,
wherein the optical semiconductor element is encapsulated with the first encapsulating material and the second encapsulating material in this order.
